# EUROPEAN PATENT APPLICATION

(11) **EP 1 447 761 A2**
(43) Date of publication of application: **18.08.2004**
(21) Application number: 04250612.1
(22) Date of filing: 05.02.2004
(51) Int. Cl.: G06F 17/50

(54) **An interactive system for detailing a complex entity**

(30) Priority: 05.02.2003 GB 0302656
(71) Applicant: FORTICRETE LIMITED, Bootle Merseyside L30 4UA (GB)
(72) Inventor: Webber, Stephen, Leighton Buzzard,Bedfordshire LU7 2TZ (GB)
(74) Representative: Ahmad, Sheikh Shakeel

(57) **Abstract**

An interactive system (10) for detailing a complex entity comprising a plurality of different user-selectable components is described. The system comprises: a data store (20) arranged to store a plurality of technical data specifications (26,28), each technical data specification relating to one of the plurality of components and comprising a plurality of user-specifiable features of that component; presentation means (12,16) for presenting one the plurality of data specifications (26,28) to a user through a graphical user interface; selecting means (16) for selecting one of the plurality of components, the selecting means (16) being arranged to enable the user to select iteratively features of a component to match a desired requirement for the complex multi-part entity; and compatibility checking means (18, 30) arranged to check the compatibility of each new selectable feature with a previously selected feature and to control the operation of the selecting means (16) to ensure that compatible selectable features are made available to the user for selection in use.

## Description

### Field of the Invention

The present invention relates to an interactive system for detailing a complex entity and more particularly, though not exclusively, to an assisted product selection system for assisting in the process of choosing components (products) for creating a composite entity, such as detailing products for creating architectural plans for a building, in particular roof detailing products which are compatible with each other to make up a composite roof structure.

### Background of the Invention

The processes involved in building a house, from concept to building, is a complex task because of the many factors and variables which are involved and the lengthy time scale from the creation of the concept of the house to be built to the completion of the building of the house. An outline of this process is as follows:
1. Creation of house concept
2. Creation of outline plans
3. Creation of detailed plans
4. Printing of detailed plans
5. Building of house according to the detailed plans

The creation of the detailed plans, at stage 3 of this procedure, normally involves the architect considering the building product to be used followed by the detailing. For example, for the roof of a house, the architect will need to decide which tile or slate he wishes to use and the pitch of the roof together with detailing of any eaves, verges, valleys, hips, ridges, ventilation, and abutment. This is a time consuming process as tile/slate and detailing products must be matched for compatibility. The process is complicated further in that not all tile/slate and detailing product combinations are available for all roof pitches. Once the architect has decided on the tile/slate and detailing, he must create detailed plans himself incorporating his choice of roofing products.

Brochures containing technical drawings of these roofing and detailing products are produced by the product manufacturers, which the architects use during their detailed plan drafting. The brochures have also been known to set out the compatibility of using each of their tiles with their detailing products. However, the architect must work though the brochure manually and once he has decided on the product combination, he must draw out the products manually to create the detailed plans. This is a time consuming process and the end technical drawing can look unprofessional or can even be inaccurate.

It is known for manufacturers of building and roofing products to provide architectural drawings of their products in an electronic format so that the architects can produce the detailed drawings electronically using software such as AutoCAD®. AutoCAD® is a general purpose computer aided drafting application program designed for use on personal computers and graphics workstations. The software permits a user to construct or edit a drawing on a graphics display screen. To aid the architect in choosing a product, these manufacturers also provide electronic brochures (e.g. in pdf file format for viewing using Adobe Acrobat® software) with illustrations or descriptions of their products. The product illustrations in the brochures can have links to the corresponding product drawing file so that selecting a product in the brochure illustration will retrieve the corresponding product drawing file for viewing and/or editing in the AutoCAD® application.

Although this eliminates the need for the architect to draw manually the detailed plans, the architect must still spend considerable time looking through the manufacturer's product compatibility tables in order to choose compatible tile and detailing products. As the combination of products is up to the architect, an incompatible product combination choice may not be picked up until the building stage which can be both dangerous and expensive.

The problems outlined above specifically in relation to construction are also applicable to any process where a complex entity needs to be specified accurately.

It is desired to overcome or substantially reduce at least some of the above-described problems.

### Summary of the Invention

In one of its broadest aspects the present invention concerns an assisted product selection system for specifying different components of a complex entity to be constructed, wherein the system has access to the product specifications of each of the components and is arranged to restrict an operator's choice of a next component on the basis of compatibility with a previous component or failure of a component selected for the multi-part entity. The present invention may be further enhanced by the provision of a last product feature selected facility whereby data entry by the operator can be made easier if many different components of the same product class and range are to be specified.

More specifically, according to one aspect of the present invention there is provided an interactive system for detailing a complex entity comprising a plurality of different user-selectable components, the system comprising: a data store arranged to store a plurality of technical data specifications, each technical data specification relating to one of the plurality of components and comprising a plurality of user-specifiable features of that component; presentation means for presenting one the plurality of data specifications to a user through a graphical user interface; selecting means for selecting one of the plurality of components, the selecting means being arranged to enable the user to select iteratively features of a component to match a desired requirement for the complex multi-part entity; and compatibility checking means arranged to check the compatibility of each new selectable feature with a previously selected feature and to control the operation of the selecting means to ensure that compatible selectable features are made available to the user for selection in use.

The present invention therefore provides the specific advantage of being able to provide the user with details of technical information regarding components of a complex entity whilst at the same time assisting him or her in the specification or detailing of the complex entity, such as a multi-element and multi-feature roof. The assistance is to automatically filter out incompatible features of components when in the process of specifying the required features of a component, such as a specific roof tile. This greatly assists in the user being able to specify the complex entity far more quickly and accurately as cross-referencing technical information in different product brochures is no longer required and the automated process is not susceptible to human error.

The term 'feature', as used throughout the present application, is intended to have a broad meaning, namely any quality which can and is attributed to the component for its use in construction (specification) of the composite entity. For example, if the colour of a component is used in distinguishing one commercial component from another, then this can be considered to be a feature of the component. Also the term 'complex' as used throughout the claims is intended to reflect the nature of the entity, namely that it is composed of many different components and their combination is non-trivial task which requires visualisation, planning and accurate specification prior to assembly or construction.

Preferably the system is arranged to construct a composite graphical representation of the complex entity, and the system further comprises: an image store for storing a plurality of images of each component according to a specific set of features; and retrieval means for retrieving from the image store a specific image corresponding to the selected component in accordance with its selected features and displaying the image to the user. This advantageously means that the system can be used very easily for the construction of detailed architect drawings of the composite complex entity without involving the user having to draw a single line. The relevant drawings, which are preferably editable, can be retrieved from a data store on the basis of the specified features of their technical specification and can simply be forwarded to and assembled in a drawings application, for example a Computer Aided Design (CAD) application, to generate the required detailed architect drawings of the entity. In this regard, the system may itself comprise such a drawings application arranged to enable construction of a composite image of the complex entity from received retrieved images.

The compatibility checking means may include a reference data store comprising a plurality of tables relating to different features of the components, wherein each table lists the compatible components for a given combination of features. This is one way of implementing the cross-checking required with a predetermined compatibility reference which, in particular, is fast.

Each table may also provide a cross reference to an image in the image store representing a component according to the given combination of features.

Preferably each technical data specification of a component stored in the data store comprises graphical information regarding the use of that component and the presentation means is arranged to provide the user with the graphical information via the graphical user interface. This helps in the visualisation of the component and its use prior to its inclusion in the user's detailed CAD drawings for example and is often a common part of a technical specification of products. The graphical user interface handles this graphical data with ease.

The compatibility checking means preferably further comprise a memory means arranged to store information identifying the previously selected feature or component and to configure the selecting means to present a default selection of the previously selected feature or component for new component or feature selection by the user. This advantageous feature has been discussed elsewhere in this application but does provide a quick way of data entry when selecting components for use in specifying the complex entity. The feature is based on the realisation by the inventor that in the detailing of a complex entity, it is quite common to use the same type of component repetitively over different portions of the entity and therefore the pre-selection of the type of component, for example, saves the user a considerable amount of time in a typically time-consuming data entry process.

There are many types of features which can be specified. For example, the plurality of user-specifiable features of the component can include a specific type of the component, a plurality of different ways in which the component can be used in compilation of the complex entity and specific portions of the complex entity where that component is designed to be used. There are other features which can readily be specified here which have not been mentioned.

According to another aspect of the present invention there is provided a method of specifying a complex entity comprising a plurality of different user-selectable components, the method comprising: storing a plurality of technical data specifications, each technical data specification relating to one of the plurality of components and comprising a plurality of user-specifiable features of that component and graphical information regarding the use of that component; presenting one the plurality of data specifications to a user through a graphical user interface; selecting one of the plurality of components, the selecting step enabling the user to select iteratively features of a component to match a desired requirement for the complex multi-part entity; checking the compatibility of each new selectable feature with a previously selected feature; and using the results of the checking step to control the selecting step to ensure that compatible selectable features are made available to the user for selection in use.

The present invention also extends to an interactive system for detailing a complex entity and constructing a graphical representation of the same, wherein the complex entity comprises a plurality of different user-selectable components, the system comprising: a data store arranged to store a plurality of technical data specifications, each technical data specification relating to one of the plurality of components and comprising a plurality of user-specifiable features of that component and graphical information regarding the use of that component; an image store for storing a plurality of images of each component according to a specific set of features; presentation means for presenting one the plurality of data specifications to a user through a graphical user interface; selection means arranged to enable the user to select iteratively features of a component to match a desired requirement for the complex multi-part entity; compatibility checking means arranged to check the compatibility of each new selectable feature with a previously selected feature and to control the operation of the selecting means to ensure that compatible selectable features are made available to the user for selection in use; and retrieval means for retrieving from the image store a specific image corresponding to the selected component in accordance with its selected features and displaying image to the user.

Advantageously, the architect can drop drawings straight onto plan. He does not have to draw them, therefore this is much faster than prior art methods described above and end drawings look much more professional. Additionally, the architect can invite the client to participate in the design process by accessing the system together.

It is to be appreciated that the present invention can be used as an assisted product selection system for enabling the user to select different products to form a composite complex entity.

A preferred embodiment of the present invention will now be described by way example with reference to the accompanying drawings.

### Brief Description of Drawings

Figure 1 is a schematic block diagram of a system embodying the present invention including a CAD link module, a Design Guide within a FastrackCAD database and a Memory database containing compatibility matrices;
Figure 2 is a schematic block diagram showing the CAD link module of Figure 1 in detail;
Figure 3 shows some of the compatibility matrices showing the Eaves detailing;
Figure 4 is a schematic diagram showing the linking of the different pages of the Design Guide;
Figure 5 is a flow diagram showing the steps involved in implementing a method embodying the present invention;
Figure 6 is a screen shot of a page from the Product Guide showing a link to the Design Guide;
Figure 7 is a screen shot of the contents page of the Design Guide showing all the detailing categories and detailing types within each category;
Figure 8 is a screen shot from the Design Guide showing Eaves detailing types;
Figure 9 is a screen shot of the pop-up window generated by the CAD link module and showing the product and pitch selection choices;
Figure 10 is a screen shot of a drawing, in the AutoCAD® application, of Hardrow Slates in a Traditional Eave detail at a pitch of 44°; and
Figure 11 is a screen shot of the FastrackCAD database route.

### Detailed Description of the Preferred Embodiment(s)

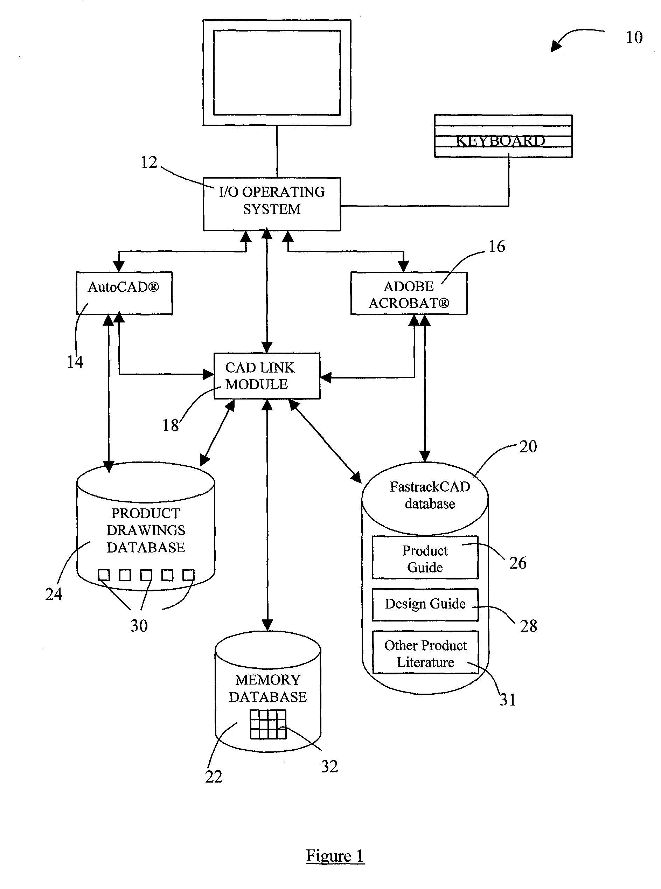

A system 10 for assisting product selection for a user is shown in Figure 1 and comprises a computer including an I/O operating system 12 through which an AutoCAD® application 14 and an Adobe Acrobat® application 16 running on the computer and a CAD link module 18 are accessible. Linked to the CAD link module 18 is a FastrackCAD database 20, a Memory database 22 and a Product Drawings database 24. Direct access to the Product Drawings database 24 and the FastrackCAD database 20 is provided from the AutoCAD® application 14 and the Adobe Acrobat® application 16, respectively.

In the present example, the user may be an architect/designer designing the roof of a building and the products are roofing products such as tiles and slates (e.g. Gemini, Minislate, Hardrow Slates, Centurion/Senator) and roof detailing (e.g. Eaves, Verge, Valley, Hip, Ridge, Ventilation and Mansard/ Abutment detailing) products, from one manufacturer. There is a compatibility issue with roofing products in general in that not all roof tiles and slates are compatible with all types of detailing e.g. a roof made of Hardrow Slates cannot have Overhanging Eave detailing. Furthermore, tiles/slates and detailing products cannot be used at all pitches and tend to have a number of suitable pitches or a suitable pitch range.

The FastrackCAD database 20, accessible through the Adobe Acrobat® application 16 and the CAD link module 18, stores product-based literature including a Product Guide 26, a Design Guide 28 and other product-related literature 31. The Product Guide 26 contains a description of the various tile and slate products including their technical specifications, illustrations and marketing material. The Design Guide 28 is a compilation of the types of roof detailing available e.g. traditional eave, overhanging eave and Hardrow slates eave for Eave detailing and a basic illustration of each. The Product Guide 26 and Design Guide 28 are stored as a portable file format (pdf), viewable through the Adobe Acrobat® application 16 or any other suitable application.

Drawings corresponding to the products in the Product Guide 26 and Design Guide 28 are stored as separate files 30 in the Product Drawings database 24. There is a separate drawing file 30 for every product at every available pitch and detailing. These files 30 are typically stored in dwg or dxf formats which can be viewed and edited in the AutoCAD® application 14 although any other compatible file type and application can be used. These product drawing files 30 can be accessed through the CAD link module 18 or directly, through the AutoCAD® application 14 or another suitable application.

The Memory database 22 stores matrices 32 containing information regarding the compatibility of the different building products with each other. The Memory database 22 also stores, or 'remembers', the last product chosen by the user (last selected features can also be remembered). The Memory database 22 can be accessed via the CAD link module 18. Although not shown explicitly in Figure 1, the FastrackCAD database 20, the Memory database 22 and the Product Drawings database 24 can also be accessed directly by applications other than the AutoCAD® application 14 and the Adobe Acrobat® application 16 associated with the I/O operating system 12.

The way in which the system 10 is used by the architect is outlined below. The architect electronically accesses (described in detail later) the Design Guide 28 and/or the Product Guide 26 through which he decides on a main tile or slate for his roof. By browsing the Design Guide 28, he can view all the different types and styles of detailing from a particular manufacturer. When he selects one detailing style from the Design Guide 28, the CAD link module 18 accesses the matrices 32 in the Memory database 22 from which it determines the products and pitches compatible with that detailing style. Consequently only compatible tile and slate products and pitches are displayed for that detailing style. This can be considered to be a form of automated filtering of information. At that stage, the architect can browse the product literature and technical specifications in the FastrackCAD database 20 for more information on each product in order to assist his product selection decision if he has not yet decided. Once the architect selects a product and pitch, the CAD link module 18 accesses the Product Drawings database 24 and retrieves a file 30 containing the relevant technical drawing of the product at the chosen pitch for the chosen detailing style. The technical drawing can then be displayed in the AutoCAD® application 14 or other compatible application and/or inserted into an existing composition. This process can be repeated for detailing other areas of the roof e.g. the ridge. The last selected product and pitch are 'remembered' by the system 10 and are entered as the default selection for the subsequent detailing product selection. In this embodiment, the CAD link module 18 only displays products and pitches as the default selection if they are compatible with that subsequent detailing type. If the last selected product and pitch are incompatible with a detailing style, the default selection remains blank. This speeds up the process of establishing a complete specification of multiple components and eliminates errors as only compatible products can be chosen for different parts of the roof.

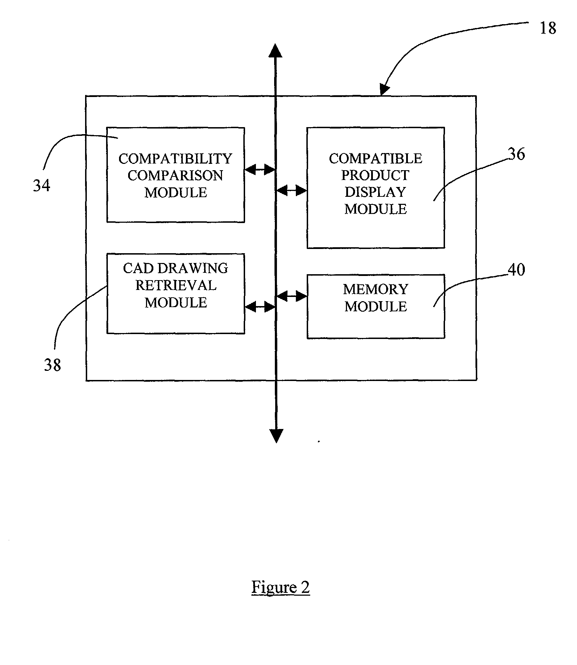

Referring now to Figure 2, the CAD link module 18 comprises various units for performing specific tasks. These include a compatibility comparison module 34, a compatible product display module 36, a CAD drawing retrieval module 38 and a memory module 40. The compatibility comparison module 34 refers to the compatibility matrices 32 in the Memory database 22 for product/pitch/detailing compatibility. The compatible product display module 36 ensures that only those products which are compatible with the detailing and pitch selection are displayed. The CAD drawing retrieval module 38 retrieves the drawing of the selected product at the selected pitch for the selected detailing style from the Product Drawings database 24 for access through the AutoCAD® application 14. The Memory module 40 'remembers' the previous product and the pitch selection and displays these as the default product and pitch. Each of these modules 34, 36, 38, 40 operate in a standard and commonly known way and so are not further described here.

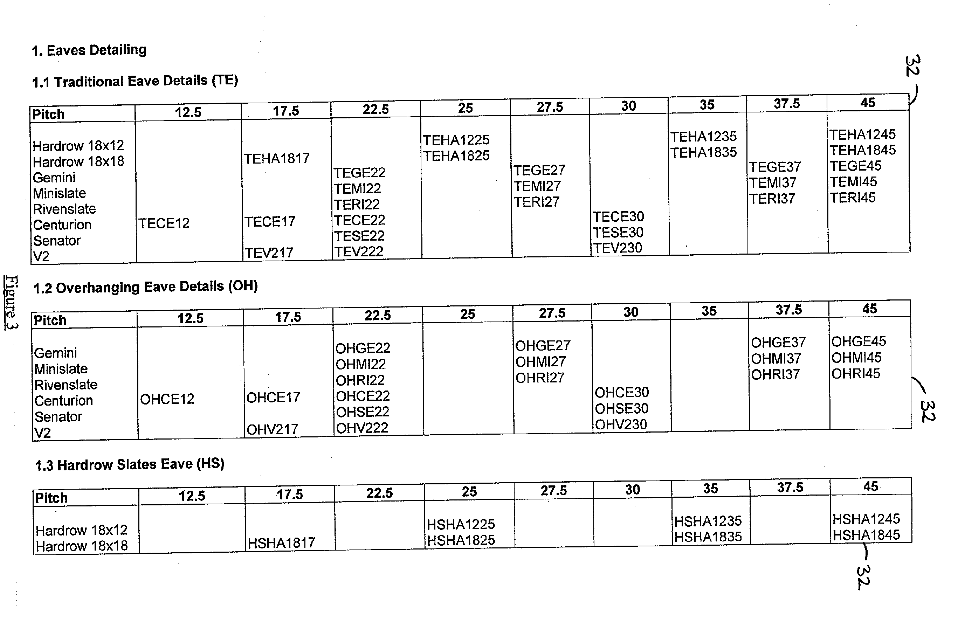

The matrices 32, to which the compatibility comparison module 34 refers, cross-reference the product, detailing and pitch for compatibility. The matrices 32 also provide the file name for the relevant product drawing. Some of the matrices 32 showing Eaves detailing (Traditional Eave details, Overhanging Eave details, and Hardrow Slates Eaves) are shown in Figure 3. For the Overhanging Eave Detail, the products available for that detailing are listed in the left-hand column. From Figure 3, it can be seen that all the tile and slate products, except for the Hardrow tiles, are listed in that column for the Overhanging Eave Details which means that the Hardrow tiles are not available for the Overhanging Eave detailing type. Only the compatible products will be presented to the architect as products available for that detailing type. The suitability of a product at a particular pitch is determined by reading across the product row and observing the product-pitch intersection. A blank at a product-pitch intersection means that that product cannot be used at that pitch. If a product is available for a particular pitch, the product-pitch intersection contains the file name of the relevant drawing file 30 in the Product Drawing database 24. The CAD link module 18 will use this file name to retrieve a specific drawing, which shows the product with the requisite detailing at the specified pitch, once the architect has made a detailing/product/pitch selection.

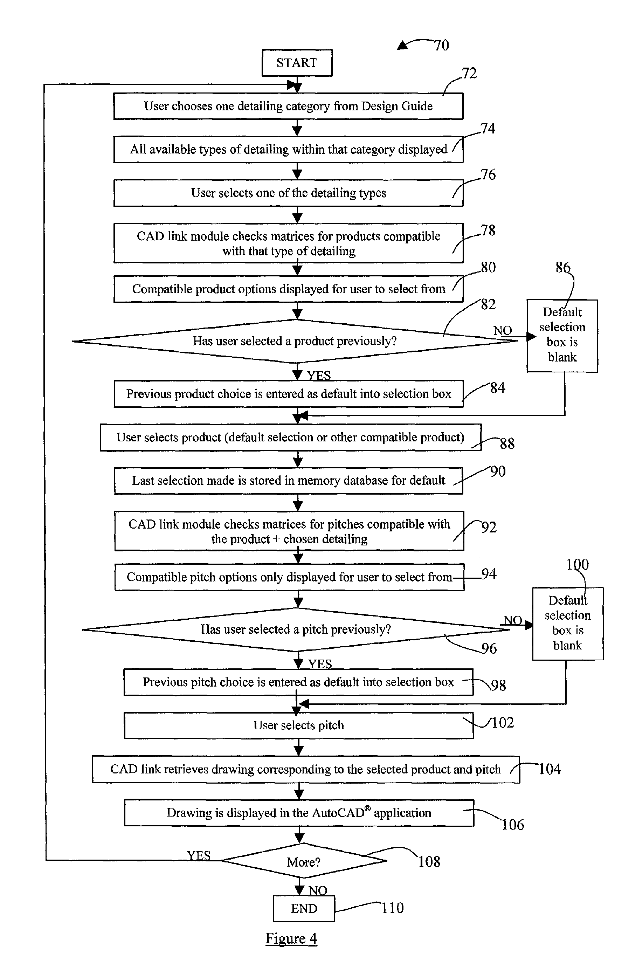

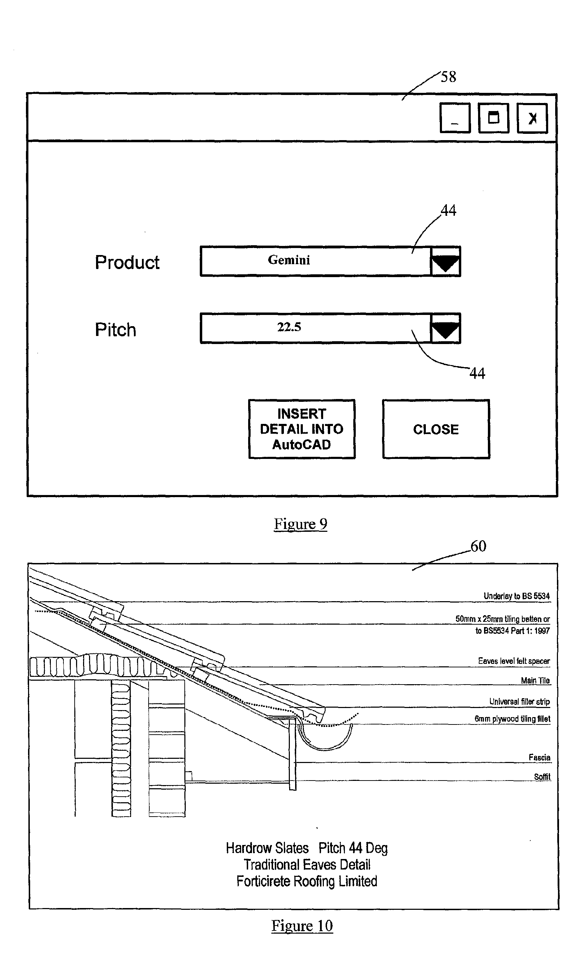

Referring to Figure 4, a method 70 of selecting compatible products and roof detailing at compatible pitches using the system 10 is now described in detail. The method 70 commences with a user electronically selecting, at Step 72, a detailing category from the Design Guide 28 e.g. eaves, verge, valley, hip, ridge, ventilation and mansard/abutment detailing. The different types of detailing within that category are displayed at Step 74 e.g. Traditional eave, Overhanging eave and Hardrow slates eave in the Eaves detailing category. When the user selects at Step 76 one detailing type (say Traditional Eave detailing), the CAD link module 18 accesses at Step 78 the matrices 32 in the Memory database 22 to establish and display at Step 80 to the user only the Traditional Eave detailing compatible products (in this case Gemini, Hardrow Duets, Hardrow Solos, Minislate, Rivenslate, Senator, and V2 tiles). A check is made at Step 82 to determine if the user has made a previous product selection (e.g. Gemini tiles were selected for Undercloak Verge detailing). If so, then that product selection (Gemini) appears at Step 84 by default in a selection box 44 (see Figure 9) presented to the user. If this is the first product selection by the user, or if the previous product selection is incompatible with that detailing type, the selection box 44 will, at Step 86, be empty. The user's product selection made at Step 88 is stored at Step 90 in the Memory database 22 so that it can be provided as the default selection for the next product selection by the user. If appropriate, the user selects a pitch (N.B. pitch selection may not be relevant for all detailing options). As before, the CAD link module 18, at Step 92, accesses the matrices 32 in the Memory database 22 and displays at Step 94 only the pitches relevant for that particular product and for that particular roof detailing. Again, a check is made at Step 96 to determine if the user has made a previous pitch selection. If so, then that pitch selection will appear at Step 98 by default in the selection box 44. If this is the first pitch selection by the user, or if the previous product selection is incompatible with that detailing type, the selection box 44 will at Step 100 be empty. The user's pitch selection is made at Step 102 and is stored in the Memory database 22 so that it can be provided as the default selection for the next pitch selection by the user. Once the product and pitch have been selected, the CAD link module 18 accesses at Step 104 the corresponding drawing file 30 from the Product Drawings database 24 and is displayed at Step 106 by the AutoCAD® application 14.

A check is made at Step 108 to determine whether to continue the process. If there are more products to be selected, the user returns to the Design Guide 28 to choose another detailing category (Step 72). The CAD link module 18 automatically presents the previously chosen product and pitch as the default selection. As stated above, if the previously chosen product and pitch are not compatible with that detailing choice then the selection box 44 remains blank. The rest of the method 70 is as before (Steps 72 to 108) and culminates in another drawing being displayed at Step 106 in the AutoCAD® application 14. The addition of drawings in the AutoCAD® application 14 is cumulative. When no further drawings are to be added, the method 70 ends at Step 110.

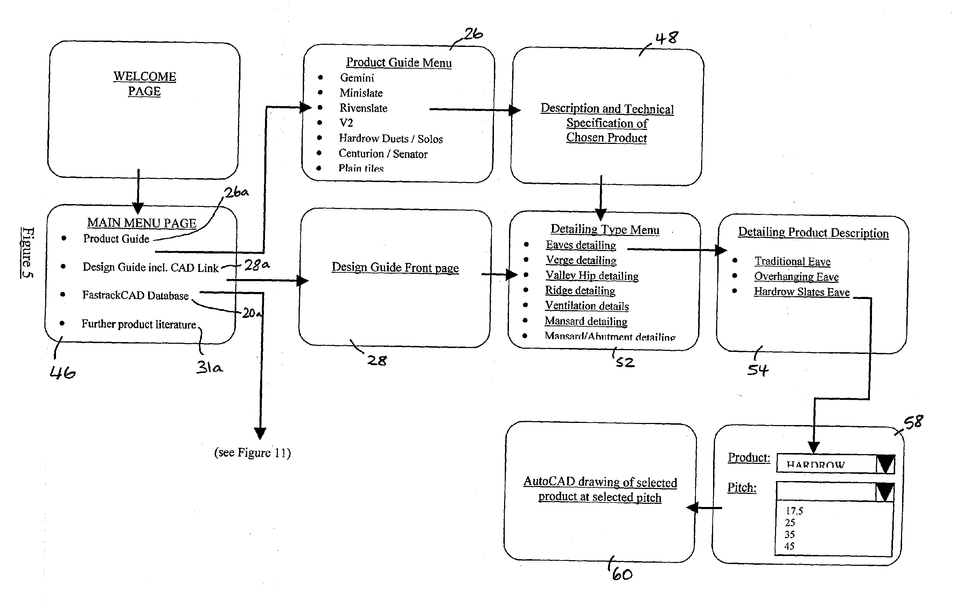

An example of the structure of the different pages and components of one manufacturer's Design Guide 28 and Product Guide 26 is shown in Figure 5. The Product Guide 26, Design Guide 28, FastrackCAD database 20 and further product literature 31 can be accessed through respective links 26a, 28a, 20a, 31a in a Main Menu Page 46. In this embodiment, the CAD link module 18 can be accessed through the either the Design Guide 28 or the Product Guide 26. The further product literature 31 can include information related to the products, for example, information on Dry Fix and Ventilation Systems, product specification guides, lead sheet association drawings, and questionnaires. The FastrackCAD database link 20a provides an alternative method of accessing the AutoCAD® drawings of the products not involving the CAD link module 18, and is described later with reference to Figure 11.

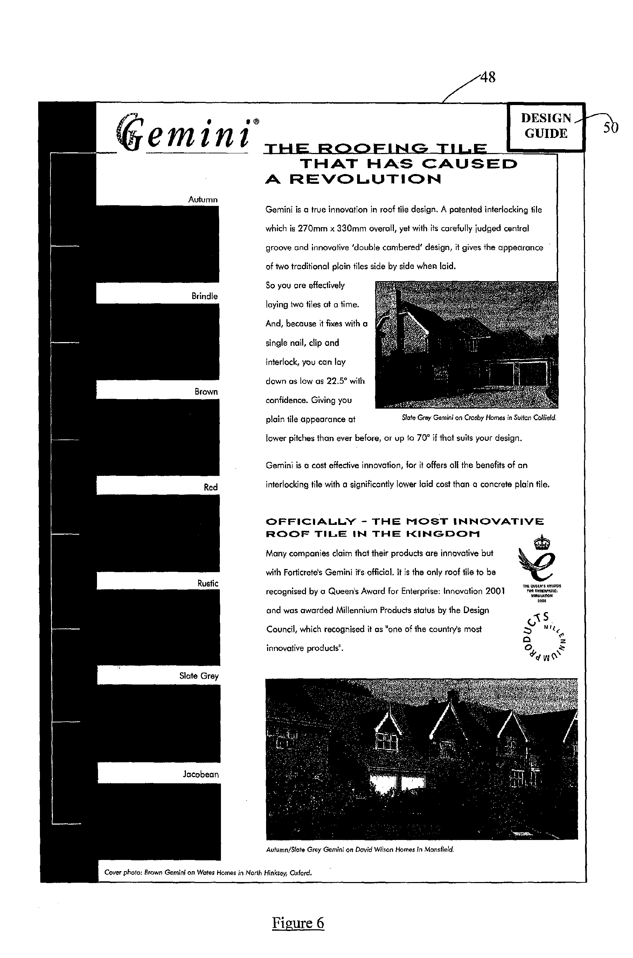

The Product Guide 26 provides promotional literature and technical information on each tile and slate product including their technical specifications and fixing methods. A screen shot of a description page 48 of the Gemini tile in the Product Guide 26 can be seen in Figure 6. A link 50 is provided from each product description page 48 to the Design Guide 28 through which the CAD link module 18 can be accessed by user selection.

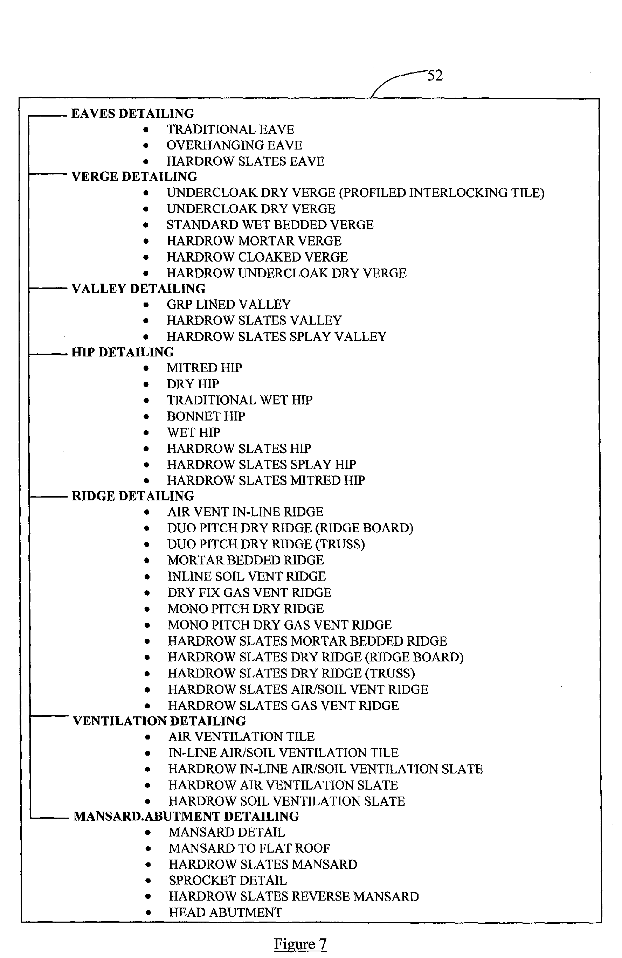

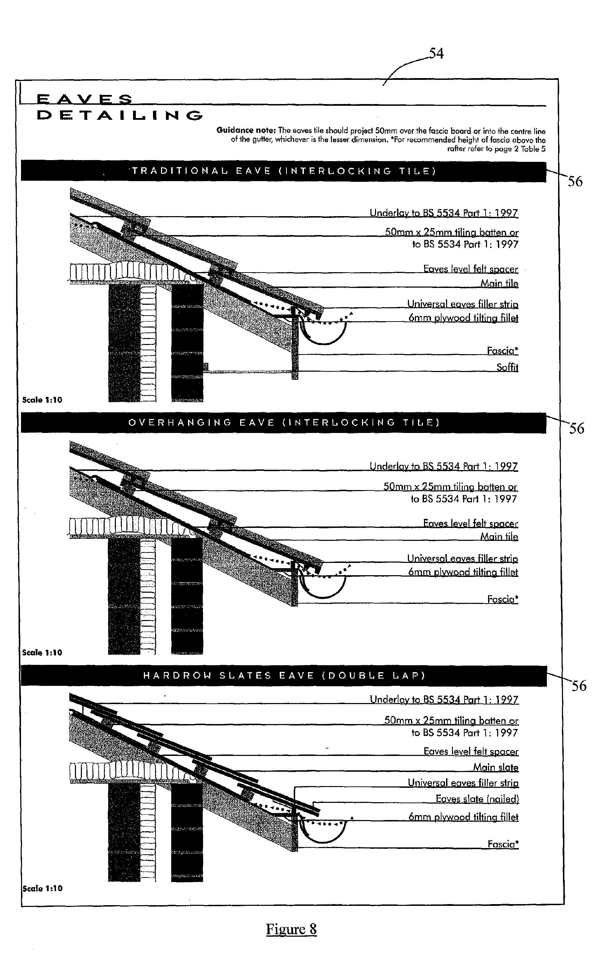

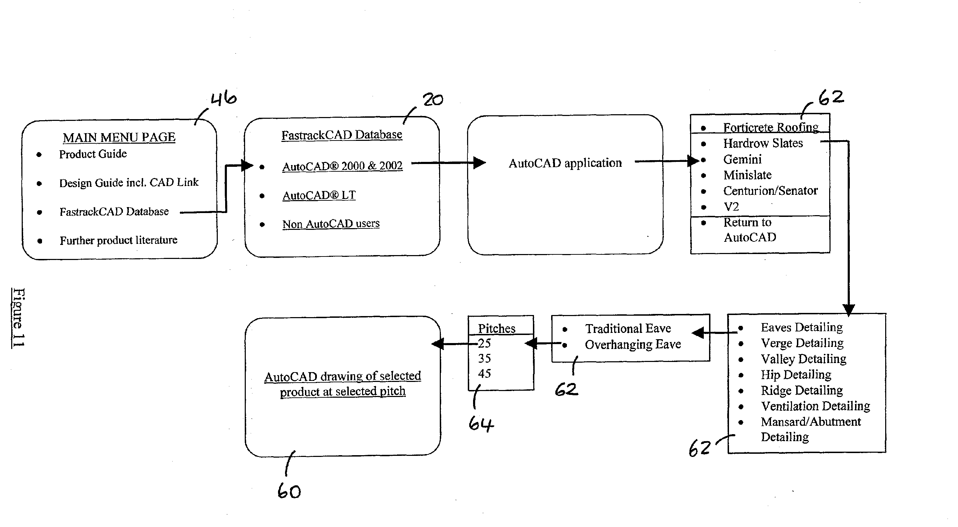

The Design Guide 28 contains all the different detailing categories provided by that manufacturer and the detailing types for each category. The contents page 52 contains a list of all the detailing types and their respective categories, a screen shot of which is shown in Figure 7. A screen shot of a Design Guide page 54 illustrating graphically three Eaves detailing styles is shown in Figure 8. When the user clicks on a title bar 56 of a detailing type e.g. Hardrow Slates Eave detailing, a pop-up window 58 (see Figure 9), generated by the CAD link module 18, appears for product and pitch selection. A screen shot of such a pop-up window 58 is shown in Figure 9. The window 58 contains the previously mentioned selection box 44 for the user to specify product and pitch as well as a drop-down menu for both product and pitch selection (not shown). Only the products and pitches compatible with that detailing type are displayed as user-selectable options in the drop-down menus. The other product and pitch possibilities are filtered out by the CAD link module 18 on the basis of the compatibility matrices 32 stored in the Memory database 22. The selection boxes 44 for both product and pitch, by default, contain the name of the product and pitch previously selected by the user. If no previous selection has been made, or if the previous selection is incompatible with the present detailing style, then the selection box 44 remains blank. Once user selection of product/detailing/pitch is complete, the appropriate drawing is inserted into the AutoCAD® application 14. An example of an AutoCAD® drawing 60 of Hardrow Slates in a traditional eaves detail at a pitch of 44°, which has been selected by the user, can be seen in Figure 10.

The specific drawings 60 of a product in a specific detailing at a specific pitch can also be accessed through the FastrackCAD Database link 20a and is presented here solely for comparison purposes as this is a known method of making a product drawing selection through the AutoCAD® application 14. In this known method, the user is presented with a series of drop down lists 62 (Figure 11) or pop-up windows (not shown) in the AutoCAD® application 14, or any other compatible application, through which a product, detailing type, and pitch selection can be made which accesses the relevant drawing file 30 from the Product Drawings database 24. In the example shown here, the product drop down lists 62, 64 display all the available products. When one product is selected, only the detailing types and styles available in the selected product are displayed in the next drop down list. Finally, the available pitches for the selected product and pitch style are presented in the last drop down list 64. Although this feature has been described with the product being selected before the detailing style, it is also possible to select the detailing style before selecting the product. This FastrackCAD Database 20 route does not involve a link from the manufacturer's brochure to the AutoCAD® application 14 and therefore requires the user to have prior knowledge of what product and detailing he requires before selecting. Additionally, using this route, the CAD link module 18 is not accessed and so there is no last selected product memory function which means that when the user returns to another detailing type product selection, he must go through the same drop down list process to select his product which is time consuming and inconvenient.

Having described a particularly preferred embodiment of the present invention, it is to be appreciated that the embodiment in question is exemplary only and that variations and modifications such as will occur to those possessed of the appropriate knowledge and skills may be made without departure from the scope of the invention as set forth in the appended claims. For example, the present invention is not restricted to roofing products. The invention is applicable to any product with multiple independent components requiring a complex specification process which is made easier and more accurate by the present invention. The Design Guide 28 can also be stored and accessed on CD ROM or through a wide area network e.g. world wide web. The Design Guide 28 can incorporate more than one manufacturer's products in which case further matrices 32 are added to the Memory database 22. Matrices 32 setting out the compatibility of different manufacturer's products and detailing types with each other may also be included so that a user may mix and match products from different manufacturer's with one detailing type or roof, for example.

## Claims

1. An interactive system for detailing a complex entity comprising a plurality of different user-selectable components, the system comprising:
a data store arranged to store a plurality of technical data specifications, each technical data specification relating to one of the plurality of components and comprising a plurality of user-specifiable features of that component;
presentation means for presenting one the plurality of data specifications to a user through a graphical user interface;
selecting means for selecting one of the plurality of components, the selecting means being arranged to enable the user to select iteratively features of a component to match a desired requirement for the complex multi-part entity; and
compatibility checking means arranged to check the compatibility of each new selectable feature with a previously selected feature and to control the operation of the selecting means to ensure that compatible selectable features are made available to the user for selection in use.

2. A system according to Claim 1, wherein the system is arranged to construct a composite graphical representation of the complex entity, the system further comprising:
an image store for storing a plurality of images of each component according to a specific set of features; and
retrieval means for retrieving from the image store a specific image corresponding to the selected component in accordance with its selected features and displaying the image to the user.

3. A system according to Claim 2, wherein the retrieval means is arranged to forward the retrieved image to a drawing application for display to the user.

4. A system according to Claim 3, further comprising a drawing application arranged to enable construction of a composite image of the complex entity from received retrieved images.

5. A system according to Claim 4, wherein the retrieved images are editable.

6. A system according to Claim 4 or 5, wherein the drawing application comprises a computer aided design (CAD) application.

7. A system according to any preceding claim, wherein the compatibility checking means includes a reference data store comprising a plurality of tables relating to different features of the components, wherein each table lists the compatible components for a given combination of features.

8. A system according to Claim 7 as dependent on any of Claims 2 to 6, wherein each table also provides a cross reference to an image in the image store representing a component according to the given combination of features.

9. A system according to any preceding claim, wherein each technical data specification of a component stored in the data store comprises graphical information regarding the use of that component and the presentation means is arranged to provide the user with the graphical information via the graphical user interface.

10. A system according to any preceding claim, wherein the compatibility checking means further comprises a memory means arranged to store information identifying the previously selected feature or component and to configure the selecting means to present a default selection of the previously selected feature or component for new component or feature selection by the user.

11. A system according to any preceding claim, wherein the plurality of user-specifiable features of the component includes a specific type of component.

12. A system according to any preceding claim, wherein the plurality of user-specifiable features of the component includes a plurality of different ways in which the component can be used in compilation of the complex entity.

13. A system according to any preceding claim, wherein the plurality of user-specifiable features of the component include specific portions of the complex entity where that component is designed to be used.

14. A method of specifying a complex entity comprising a plurality of different user-selectable components, the method comprising:
storing a plurality of technical data specifications, each technical data specification relating to one of the plurality of components and comprising a plurality of user-specifiable features of that component and graphical information regarding the use of that component;
presenting one the plurality of data specifications to a user through a graphical user interface;
selecting one of the plurality of components, the selecting step enabling the user to select iteratively features of a component to match a desired requirement for the complex multi-part entity;
checking the compatibility of each new selectable feature with a previously selected feature; and
using the results of the checking step to control the selecting step to ensure that compatible selectable features are made available to the user for selection in use.

15. An interactive system for detailing a complex entity and constructing a graphical representation of the same, wherein the complex entity comprises a plurality of different user-selectable components, the system comprising:
a data store arranged to store a plurality of technical data specifications, each technical data specification relating to one of the plurality of components and comprising a plurality of user-specifiable features of that component and graphical information regarding the use of that component;
an image store for storing a plurality of images of each component according to a specific set of features;
presentation means for presenting one the plurality of data specifications to a user through a graphical user interface;
selection means arranged to enable the user to select iteratively features of a component to match a desired requirement for the complex multi-part entity;
compatibility checking means arranged to check the compatibility of each new selectable feature with a previously selected feature and to control the operation of the selecting means to ensure that compatible selectable features are made available to the user for selection in use; and
retrieval means for retrieving from the image store a specific image corresponding to the selected component in accordance with its selected features and displaying image to the user.
